(19) Europäisches Patentamt
European Patent Office
Office européen des brevets

(11) EP 4 679 493 A1

(12) EUROPEAN PATENT APPLICATION
published in accordance with Art. 153(4) EPC

(43) Date of publication:
**14.01.2026 Bulletin 2026/03**

(21) Application number: **24770806.8**

(22) Date of filing: **08.03.2024**

(51) International Patent Classification (IPC):
***H01L 21/304*** (2006.01) ***C09J 11/06*** (2006.01)
***C09J 183/04*** (2006.01) ***H01L 21/683*** (2006.01)

(52) Cooperative Patent Classification (CPC):
**C09J 11/06; C09J 183/04; H01L 21/304; H01L 21/683**

(86) International application number:
**PCT/JP2024/009173**

(87) International publication number:
**WO 2024/190700 (19.09.2024 Gazette 2024/38)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **10.03.2023 JP 2023037576**

(71) Applicant: **SHIN-ETSU CHEMICAL CO., LTD.**
**Tokyo 1000005 (JP)**

(72) Inventors:
- **MUTO Mitsuo**
  **Annaka-shi, Gunma 379-0224 (JP)**
- **SUGO Michihiro**
  **Annaka-shi, Gunma 379-0224 (JP)**

(74) Representative: **Schicker, Silvia**
**Wuesthoff & Wuesthoff**
**Patentanwälte und Rechtsanwalt PartG mbB**
**Schweigerstraße 2**
**81541 München (DE)**

# (54) METHOD FOR PRODUCING THIN WAFER, WAFER LAMINATE AND TEMPORARY ADHESIVE FOR WAFER PROCESSING

(57) The present invention is a method for producing a thin wafer using a thermosetting silicone resin composition as a temporary adhesive for wafer processing for allowing a wafer to temporarily adhere to a support, in which the thermosetting silicone resin composition can be cured only by heating and includes the following components: (A) an organopolysiloxane having two or more alkenyl groups in one molecule, (B) an organohydrogenpolysiloxane containing two or more silicon atom-bonded hydrogen atoms (SiH groups) in one molecule, (C) an organic peroxide, and (D) a radically activated hydrosilylation reaction catalyst. Thereby, a method for producing a thin wafer, using a temporary adhesive for wafer processing, which has sufficient substrate holdability after bonding even when a substrate with a high stepped section height is used, is highly compatible with a wafer back surface grinding process, a TSV formation process, and a wafer back surface wiring process, also has excellent wafer thermal process resistance, also has excellent long-term storage stability of the composition, and furthermore exhibits stable substrate holdability, peelability, and substrate residue cleanability after peel for any substrate, is provided.



Processed by Luminess, 75001 PARIS (FR)

## Description

### TECHNICAL FIELD

The present invention relates to: a method for producing a thin wafer, a wafer laminate, and a temporary adhesive for wafer processing to be used therefor.

### BACKGROUND ART

Three-dimensional semiconductor packaging has become essential to achieve even higher density and capacity. The three-dimensional packaging technology is a semiconductor manufacturing technology that makes a single semiconductor chip thin and stacks it in multiple layers while connecting it with a through silicon via (TSV). In order to realize this, a process is required to make a substrate thin on which a semiconductor circuit is formed, by grinding a circuit-free surface (also called the "back surface") and further to form an electrode including a TSV on the back surface. Conventionally, in a back surface grinding process of a silicon substrate, a back surface protective tape attaches to the opposite side of a grinding surface to prevent the wafer from being damaged upon grinding. However, this tape uses an organic resin film as a supporting substrate, and although it is flexible, its strength and heat resistance are insufficient, making it unsuitable for a TSV formation process or a wiring layer formation process on a back surface.

Therefore, systems have been proposed that can withstand processes such as back surface grinding and TSV and back surface electrode formation by bonding a semiconductor substrate to a support such as silicon or glass via an adhesive layer. What is important in this case is an adhesive layer to be used when bonding the substrate to the support. This is required to be capable of bonding the substrate to the support without gaps, to be durable enough to withstand subsequent processes, and further to finally allow the thin wafer to be peeled off from the support easily. Since it is peeled at the end, this adhesive layer is also referred to as a temporary adhesive layer as used herein.

Conventionally, as publicly known temporary adhesive layers and peeling methods thereof, there are proposed a technology whereby an adhesive containing a light-absorbing substance is irradiated with high-intensity light to decompose an adhesive layer, which is then peeled off from a support (Patent Document 1), and a technology whereby a heat-meltable hydrocarbon compound is used as an adhesive and undergoes bonding and peeling processes in a heated and molten state (Patent Document 2). The former technology has problems such as being required to be equipped with an expensive apparatus such as a laser and a long time taken for processing one substrate. Moreover, the latter technique is simple because it can be controlled only by heating, whereas it can only be applied in a narrow range because it has insufficient thermal stability at elevated temperatures exceeding 200°C. Furthermore, these temporary adhesive layers are not suitable for forming of film with a uniform thickness on a substrate with a high stepped section height, and for complete adhesion to a support.

Moreover, technologies using a silicone adhesive as a temporary adhesive layer have also been proposed. This is a technology whereby a substrate adheres to a support using a silicone adhesive of hydrosilylation addition cure type, and when peeled, they are immersed in a chemical that dissolves or decomposes a silicone resin, to separate the substrate from the support (Patent Document 3). Therefore, it takes an extremely long time for peel, making it difficult to apply the technology to an actual manufacturing process. Moreover, after peel, it also takes a long time to clean off a silicone adhesive remaining on the substrate as a residue, also leaving a problem in terms of cleaning removability.

Moreover, silicone adhesive compositions of hydrosilylation addition cure type increase in viscosity over time during long-term storage, which has posed a problem of long-term storage stability of the composition such as when coating a wafer therewith, a resin thickness changes.

Furthermore, in order to impart heat resistance and chemical resistance to a substrate, its surface may be preliminarily treated or coated with an oxide film, a nitride film, an organic resin film, or the like, however, there is also a problem that depending on the type of chemical modification of such a substrate surface, a hydrosilylation reaction is affected by a platinum catalyst, as a result of which the adhesiveness between a silicone resin and the substrate changes, making it unable to obtain stable wafer processability or peelability of the support.

### CITATION LIST

### PATENT LITERATURE

Patent Document 1: JP 2004-64040 A
Patent Document 2: JP 2006-328104 A
Patent Document 3: US 7541264B1

## SUMMARY OF INVENTION

### TECHNICAL PROBLEM

The present invention has been made in view of the above problems, and aims to provide: a method for producing a thin wafer, a wafer laminate, and a temporary adhesive for wafer processing, using a temporary adhesive for wafer processing, which has sufficient substrate holdability after bonding even when a substrate with a high stepped section height is used, is highly compatible with a wafer back surface grinding process, a TSV formation process, and a wafer back surface wiring process, has excellent wafer thermal process resistance, has excellent long-term storage stability of the composition, and also exhibits stable substrate holdability, peelability, and substrate residue cleanability after peel for any substrate.

### SOLUTION TO PROBLEM

To solve the problems, the present invention provides a method for producing a thin wafer using a thermosetting silicone resin composition as a temporary adhesive for wafer processing for allowing a wafer to temporarily adhere to a support, wherein the thermosetting silicone resin composition can be cured only by heating and includes the following components:

(A) an organopolysiloxane having two or more alkenyl groups in one molecule in an amount of 100 parts by mass,
(B) an organohydrogenpolysiloxane comprising two or more silicon atom-bonded hydrogen atoms (SiH groups) in one molecule in an amount such that a mole ratio of a total of SiH groups in component (B) to a total of alkenyl groups in component (A) is from 0.3 to 10,
(C) an organic peroxide in an amount of 0.01 to 20 parts by mass, and
(D) a radically activated hydrosilylation reaction catalyst in an amount of 0.1 to 5,000 ppm in terms of metal atom amount based on a total mass of the component (A) and the component (B).

The method for producing a thin wafer of the present invention is applicable to a wide range of semiconductor film deposition processes due to flexibility and excellent heat resistance of a silicone resin, also has excellent CVD (chemical vapor deposition) resistance, can form a temporary adhesive layer with high film thickness uniformity even on wafers with stepped sections, and can easily fabricate a uniform thin wafer of 50 μm or less resulting from its film thickness uniformity. Also, after fabrication of thin wafer, the wafer can be easily peeled off from a support, for example at room temperature, and the peel interface can be controlled at between the wafer and the temporary adhesive layer, facilitating residues to be cleaned on the wafer after peel, and making it possible to improve production workability of breakable thin wafers.
In this case, it is preferable that a thermosetting silicone resin composition used further comprises, as component (E), a non-functional organopolysiloxane in an amount of 0.1 to 200 parts by mass.
Such a thermosetting silicone resin composition further containing a non-functional organopolysiloxane as component (E) can be easily peeled in the step of peeling off a support from a substrate, while preventing a wafer from being peeled off upon wafer processing such as wafer back surface grinding and subsequent heat treatment, thereby achieving wafer processing durability.
In this case, it is further preferable that the non-functional organopolysiloxane as the component (E) is composed of dimethylpolysiloxane, and a 30% by mass toluene solution thereof has a viscosity at 25°C of 100 to 500,000 mPa·s. This viscosity is more preferably 1,000 to 400,000 mPa·s and still more preferably 10,000 to 300,000 mPa·s.
Within such a range of the viscosity, the non-functional organopolysiloxane has an appropriate molecular weight, as a result of which, when the silicone resin composition is heated and cured, it does not volatilize, making it less likely not to obtain the desired effect, and does not cause a wafer to crack in wafer thermal process such as CVD, and has favorable workability and coatability, which is preferred.
Also, in the method for producing a thin wafer of the present invention, the organic peroxide is preferably at least one selected from the group consisting of a diacyl peroxide, a peroxy ester, a dialkyl peroxide, a percarbonate, a peroxy ketal, a hydroperoxide, and a ketone peroxide.
The organic peroxide to be used in the present invention is preferable in order to allow these to provide catalytic activity of component (D).
The organic peroxide preferably has a 10-hour half-life temperature of 40°C or higher and a 1-minute half-life temperature of 200°C or lower.
The use of such organic peroxides is effective in achieving both high reactivity and a long shelf life.
Furthermore, it is preferable that a thermosetting silicone resin composition used further comprises, as component (F), a hydrosilylation reaction control agent in an amount of 0.001 to 10 parts by mass based on a total mass of the components (A) and (B).

Using such a reaction control agent can prevent the composition from increasing its viscosity or causing gelation upon long-term storage.

Also, the thermosetting silicone resin composition preferably has a 180° peel strength at 25°C after curing of 2 gf or more and 500 gf or less when a test specimen with a width of 25 mm is peeled from a silicon substrate.

Using the thermosetting silicone resin composition that has such peel strength after curing, does not allow the wafer to have a risk of being misaligned upon wafer grinding, and facilitates a support to be peeled off.

Also, the thermosetting silicone resin composition preferably has a storage modulus at 25°C after curing of 1,000 Pa or more and 1,000 MPa or less.

Using the thermosetting silicone resin composition having such a storage modulus prevents a wafer from being misaligned upon wafer grinding, and it is stable upon thermal processing of a wafer.

Also, the present invention also provides: the method for producing a thin wafer according to any one described above, comprising the steps of:

(a) allowing a circuit-forming surface of a wafer having the circuit-forming surface on a front surface and a circuit-free surface on a back surface to peelably adhere to a support using the temporary adhesive for wafer processing to form a wafer laminate;
(b) thermally curing the temporary adhesive;
(c) grinding or polishing the circuit-free surface of the wafer in the wafer laminate;
(d) subjecting the circuit-free surface of the wafer to processing; and
(e) peeling off the wafer subjected to the processing from the support.

Also, the present invention also provides a temporary adhesive for wafer processing applicable to a thin wafer or a wafer laminate, wherein the temporary adhesive for wafer processing is composed of a thermosetting silicone resin composition comprising the following components:

(A) an organopolysiloxane having two or more alkenyl groups in one molecule in an amount of 100 parts by mass,
(B) an organohydrogenpolysiloxane comprising two or more silicon atom-bonded hydrogen atoms (SiH groups) in one molecule in an amount such that a mole ratio of a total of the SiH groups in component (B) to a total of alkenyl groups in component (A) is from 0.3 to 10,
(C) an organic peroxide in an amount of 0.01 to 20 parts by mass, and
(D) a radically activated hydrosilylation reaction catalyst in an amount of 0.1 to 5,000 ppm in terms of metal atom amount based on a total mass of the component (A) and the component (B).

Such a temporary adhesive for wafer processing of the present invention is applicable to a wide range of semiconductor film deposition processes due to flexibility and excellent heat resistance of the silicone resin, also has excellent CVD (chemical vapor deposition) resistance, also can form a temporary adhesive layer with high film thickness uniformity even on wafers with stepped sections, and can easily fabricate a uniform thin wafer of 50 μm or less due to its film thickness uniformity. Also, after fabrication of thin wafer, the wafer can be easily peeled off from a support, for example at room temperature, so that a peel interface can be controlled at between the wafer and the temporary adhesive layer, facilitating residues to be cleaned on the wafer after peel, and making it possible to improve production workability of breakable thin wafers. Furthermore, the thermosetting silicone resin composition to be used in the temporary adhesive of the present invention also has excellent long-term storage stability, so that after production of composition, it is possible to obtain the above-mentioned stable performance over a long period of time.

In this case, it is preferable that the thermosetting silicone resin composition further comprises, as component (E), a non-functional organopolysiloxane in an amount of 0.1 to 200 parts by mass.

Such a temporary adhesive for wafer processing further containing a non-functional organopolysiloxane as the component (E) can be easily peeled off in the step of peeling off a support from a substrate, while preventing a wafer from being peeled off upon wafer processing such as wafer back surface grinding and subsequent heat treatment, thereby achieving wafer processing durability.

In this case, the non-functional organopolysiloxane of the component (E) is composed of dimethylpolysiloxane, and a 30% by mass toluene solution thereof has a viscosity at 25°C of 100 to 500,000 mPa·s. This viscosity is more preferably 1,000 to 400,000 mPa·s and still more preferably 10,000 to 300,000 mPa·s.

Within such a range of the viscosity, the non-functional organopolysiloxane has an appropriate molecular weight, as a result of which, when the silicone resin composition is heated and cured, it does not volatilize, making it less likely not to obtain the effect, and does not cause a wafer to crack in wafer thermal process such as CVD, and has favorable workability and coatability, which is preferred.

Also, in the temporary adhesive for wafer processing of the present invention, the organic peroxide is preferably at least one selected from the group consisting of a diacyl peroxide, a peroxy ester, a dialkyl peroxide, a percarbonate, a

peroxy ketal, a hydroperoxide, and a ketone peroxide.

The organic peroxide to be used in the present invention is preferred in order to allow these to provide catalytic activity of component (D).

Also, the organic peroxide preferably has a 10-hour half-life temperature of 40°C or higher and a 1-minute half-life temperature of 200°C or lower.

Using such an organic peroxide makes it effective to achieve both high reactivity and a long shelf life.

Also, it is preferable that a thermosetting silicone resin composition further comprises, as component (F), a hydrosilylation reaction control agent in an amount of 0.001 to 10 parts by mass based on the total mass of the component (A) and the component (B).

Such a reaction control agent for use can prevent the composition from increasing its viscosity and causing gelation upon long-term storage.

Also, the thermosetting silicone resin composition preferably has a 180° peel strength at 25°C after curing of 2 gf or more and 500 gf or less when a test specimen with a width of 25 mm is peeled from a silicon substrate.

Using the thermosetting silicone resin composition that has such peel strength after curing, does not allow a wafer to have a risk of being misaligned upon wafer grinding, and facilitates a support to be peeled off.

Also, the thermosetting silicone resin composition preferably has a storage modulus at 25°C after curing of 1,000 Pa or more and 1,000 MPa or less.

Using the thermosetting silicone resin composition having such a storage modulus prevents a wafer from being misaligned upon wafer grinding, and it is stable upon thermal processing of a wafer.

Also, the present invention provides: a wafer laminate including a support, a temporary adhesive layer obtained from the temporary adhesive for wafer processing to be obtained from any one described above, stacked on the support, and a wafer having a circuit-forming surface on a front surface and a circuit-free surface on a back surface, wherein the temporary adhesive layer is peelably adhered to the front surface of the wafer.

Such a wafer laminate is applicable to a wide range of semiconductor film deposition processes because the temporary adhesive for wafer processing to be used for a temporary adhesive layer contains a silicone resin having flexibility and excellent heat resistance, also has excellent CVD (chemical vapor deposition) resistance, can form a temporary adhesive layer with high film thickness uniformity even on wafers with stepped sections and can easily provide a uniform thin wafer of 50 μm or less due to its film thickness uniformity. Also, after fabrication of thin wafer using the wafer laminate, the wafer can be easily peeled off from a support, for example at room temperature, and the peel interface can be controlled at between the wafer and the temporary adhesive layer, facilitating residues to be cleaned on the wafer after peel, and making it possible to improve production workability of breakable thin wafers.

## ADVANTAGEOUS EFFECTS OF INVENTION

The method for producing a thin wafer, the wafer laminate, and the temporary adhesive for wafer processing, of the present invention is applicable to a wide range of semiconductor film deposition processes due to the flexibility and excellent heat resistance of the silicone resin, also have excellent CVD (chemical vapor deposition) resistance, can form a temporary adhesive layer with high film thickness uniformity even on wafers with stepped sections and can fabricate a uniform thin wafer of 50 μm or less due to its film thickness uniformity. Also, after fabrication of thin wafer, it can be easily peeled off from a support, for example at room temperature, so that the peel interface can be controlled between the wafer and the temporary adhesive layer, facilitating residues to be cleaned on the wafer after peel, and making it possible to improve production workability of breakable thin wafers. Furthermore, the thermosetting silicone resin composition to be used in the temporary adhesive of the present invention also has excellent long-term storage stability, so that after production of composition, it is possible to obtain the above-mentioned stable performance over a long period of time. Also, even though a substrate in which a surface of a wafer to which the adhesive is to be applied is coated with a resin film or the like, is used, the thermosetting silicone resin composition is less likely to be affected by the surface coating, making it possible to exhibit stable wafer adhesiveness, wafer peelability, and residue cleanability and removability on a wafer for substrates with a wide range of materials.

## DESCRIPTION OF EMBODIMENTS

The present inventors have found as a result of diligent investigations to solve the aforementioned problems that the above problems can be solved by using a thermosetting silicone resin composition that uses a radically activated hydrosilylation reaction catalyst as a temporary adhesive, and thus have completed the present invention.

The method for producing a thin wafer of the present invention can be suitably implemented and the temporary adhesive for wafer processing of the present invention to be used for a wafer laminate can be suitably fabricated, by using a thermosetting silicone resin composition described below. Herein, in terms of applicability to a silicon wafer and the like with stepped sections, the thermosetting silicone resin composition preferably has favorable spin-coatability.

Thus, the present invention is a method for producing a thin wafer using a thermosetting silicone resin composition as a temporary adhesive for wafer processing for allowing a wafer to temporarily adhere to a support, wherein the thermosetting silicone resin composition can be cured only by heating and includes the following components:

(A) an organopolysiloxane having two or more alkenyl groups in one molecule in an amount of 100 parts by mass,
(B) an organohydrogenpolysiloxane containing two or more silicon atom-bonded hydrogen atoms (SiH groups) in one molecule in an amount such that a mole ratio of a total of SiH groups in component (B) to a total of alkenyl groups in component (A) is from 0.3 to 10,
(C) an organic peroxide in an amount of 0.01 to 20 parts by mass, and
(D) a radically activated hydrosilylation reaction catalyst in an amount of 0.1 to 5,000 ppm in terms of metal atom amount based on a total mass of the component (A) and the component (B).

Also, the present invention is a temporary adhesive for wafer processing applicable to a thin wafer or a wafer laminate, wherein the temporary adhesive for wafer processing is composed of a thermosetting silicone resin composition containing the following components:

(A) an organopolysiloxane having two or more alkenyl groups in one molecule in an amount of 100 parts by mass,
(B) an organohydrogenpolysiloxane containing two or more silicon atom-bonded hydrogen atoms (SiH groups) in one molecule in an amount such that a mole ratio of a total of SiH groups in component (B) to a total of alkenyl groups in component (A) is from 0.3 to 10,
(C) an organic peroxide in an amount of 0.01 to 20 parts by mass, and
(D) a radically activated hydrosilylation reaction catalyst in an amount of 0.1 to 5,000 ppm in terms of metal atom amount based on a total mass of the component (A) and the component (B).

Hereinafter, each component constituting the thermosetting silicone resin composition described above will be described.

[Component (A)]

The component (A) is an organopolysiloxane having two or more alkenyl groups in one molecule. Examples of the component (A) include a linear or branched diorganopolysiloxane containing two or more alkenyl groups in one molecule and an organopolysiloxane having a three-dimensional network structure containing two or more alkenyl groups in one molecule and having a siloxane unit (Q unit) represented by a $SiO_{4/2}$ unit. Of these, a diorganopolysiloxane or an organopolysiloxane having a three-dimensional network structure and an alkenyl group content rate of 0.6 to 9 mol%, is preferred. It is to be noted that the alkenyl group content rate as used herein refers to the proportion of a siloxane unit containing an alkenyl group in all siloxane units.

An example of such an organopolysiloxane includes an organopolysiloxane represented by the following formula (A-1), (A-2), or (A-3). These may be used singly or in combination of two or more thereof.

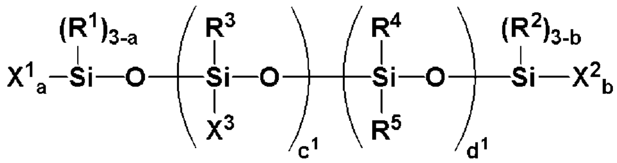
(A-1)

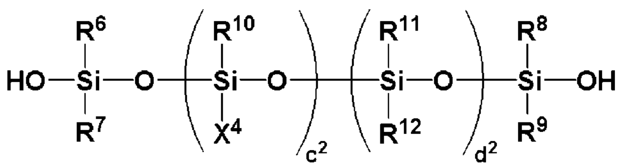
(A-2)

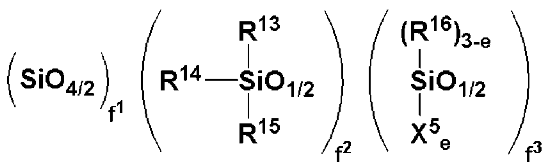
(A-3)

In formulae (A-1) to (A-3), $R^1$ to $R^{16}$ are each independently a monovalent hydrocarbon group other than an aliphatic unsaturated hydrocarbon group. $X^1$ to $X^5$ are each independently an alkenyl group-containing monovalent organic group.

In formula (A-1), a and b are each independently an integer of 0 to 3. In formulae (A-1) and (A-2), $c^1$, $c^2$, $d^1$, and $d^2$ are integers that satisfy $0 \le c^1 \le 10$, $2 \le c^2 \le 10$, $0 \le d^1 \le 100$, and $0 \le d^2 \le 100$, with the proviso that $a + b + c^1 \ge 2$. a, b, $c^1$, $c^2$, $d^1$, and $d^2$ are preferably a combination of numerals such that the alkenyl group content rate is 0.6 to 9 mol%.

In formula (A-3), e is an integer of 1 to 3. $f^1$, $f^2$, and $f^3$ are numerals such that $(f^2 + f^3)/f^1$ is 0.3 to 3.0 and $f^3/(f^1 + f^2 + f^3)$ is 0.01 to 0.6.

The monovalent hydrocarbon group other than an aliphatic unsaturated hydrocarbon group is preferably those having 1 to 10 carbon atoms, and examples thereof include alkyl groups such as a methyl group, an ethyl group, a n-propyl group, an isopropyl group, a n-butyl group, a tert-butyl group, a n-pentyl group, and an n-hexyl group; cycloalkyl groups such as a cyclopentyl group and a cyclohexyl group; and aryl groups such as a phenyl group and a tolyl group. Of these, an alkyl group such as a methyl group or a phenyl group is preferred.

The alkenyl group-containing monovalent organic group is preferably those having 2 to 10 carbon atoms, and examples thereof include alkenyl groups such as a vinyl group, an allyl group, a hexenyl group, and an octenyl group; (meth)acryloylalkyl groups such as an acryloylpropyl group, an acryloylmethyl group, and a methacryloylpropyl group; (meth)acryloxyalkyl groups such as an acryloxypropyl group, an acryloxymethyl group, a methacryloxypropyl group, and a methacryloxymethyl group; and alkenyl group-containing monovalent hydrocarbon groups such as a cyclohexenylethyl group and a vinyloxypropyl group. Among these, the vinyl group is preferred from an industrial viewpoint.

In formula (A-1), a and b are each independently an integer of 0 to 3, but when a is 1 to 3, the molecular chain end is blocked with an alkenyl group to be able to form a highly reactive alkenyl group at its molecular chain end, as a result of which the reaction can be completed in a short time, which is preferable. Also, from the viewpoint of cost, it is industrially preferable that a is 1. The properties of the alkenyl group-containing diorganopolysiloxane represented by formula (A-1) or (A-2) are preferably oily or raw rubbery.

The organopolysiloxane represented by formula (A-3) includes a $SiO_{4/2}$ unit and has a three-dimensional network structure. In formula (A-3), e is each independently an integer of 1 to 3, but from the viewpoint of cost, it is industrially preferable that e is 1. Also, a product of an average value of e and $f^3/(f^1 + f^2 + f^3)$ is preferably 0.02 to 1.5 and more preferably 0.03 to 1.0. The organopolysiloxane represented by formula (A-3) may be used as a solution dissolved in an organic solvent.

The number-average molecular weight (Mn) of the organopolysiloxane of component (A) is preferably 100 to 1,000,000, and more preferably 1,000 to 100,000. The Mn staying within the above range is preferable in terms of workability associated with the viscosity of the composition and processability associated with a storage modulus after curing. It is to be noted that the Mn as used herein is a value in terms of polystyrene, measured by gel permeation chromatography using toluene as a solvent.

Component (A) may be used singly or in combination of two or more thereof. It is particularly preferable to use a combination of the organopolysiloxane represented by formula (A-1) and the organopolysiloxane represented by formula (A-3). In this case, the amount of organopolysiloxane represented by formula (A-3) used is preferably 1 to 1,000 parts by mass and more preferably 10 to 500 parts by mass, based on 100 parts by mass of the organopolysiloxane represented by formula (A-1).

[Component (B)]

Component (B) is a crosslinking agent, and is an organohydrogenpolysiloxane having at least two, preferably three or more, silicon atom-bonded hydrogen atoms (SiH groups) in one molecule. The organohydrogenpolysiloxane may be any of linear, branched, or cyclic. The organohydrogenpolysiloxane may be used singly or in combination of two or more thereof.

The viscosity of the organohydrogenpolysiloxane of component (B) at 25°C is preferably 1 to 5,000 mPa·s and more preferably 5 to 500 mPa·s. The viscosity as used herein is a value measured at 25°C using a rotational viscometer.

The Mn of the organohydrogenpolysiloxane of component (B) is preferably 100 to 100,000 and more preferably 500 to 10,000. The Mn staying within the above range is preferable in terms of workability associated with the viscosity of the composition and processability associated with a storage modulus after curing.

Component (B) is preferably compounded so that a mole ratio (SiH group/alkenyl group) of the total of the SiH groups in component (B) to the total of the alkenyl groups in component (A) is in the range of 0.3 to 10, more preferably in the range of 0.5 to 5.0, and still more preferably in the range of 0.5 to 3.0. The mole ratio of 0.3 or more can sufficiently increases a crosslink density, and can more reliably cure the temporary adhesive layer. Also, the mole ratio of 10 or less can appropriately control a crosslink density, and can provide sufficient adhesive strength and tackiness, and can inhibit a change in adhesiveness before and after a heat treatment process.

[Component (C)]

Component (C) is an organic peroxide such that a radical generated by thermal decomposition acts on component (D) described below; a radically activated hydrosilylation reaction catalyst, to obtain catalytic activity. Examples of the organic peroxide include a diacyl peroxide, a peroxy ester, a dialkyl peroxide, a percarbonate, a peroxy ketal, a hydroperoxide, and a ketone peroxide. They may be used singly or in combination of two or more thereof.
The organic peroxide of component (C) preferably has a 10-hour half-life temperature of 40°C or higher and a 1-minute half-life temperature of 200°C or lower, from the viewpoint of achieving both high reactivity and long-term storage stability and more preferably has a 10-hour half-life temperature of 60°C or higher and a 1-minute half-life temperature of 180°C or lower. The upper limit of the 10-hour half-life temperature and the lower limit of the 1-minute half-life temperature are not limited, but are approximately 150°C or lower and approximately 100°C or higher, respectively.
Examples of the diacyl peroxide include isobutyl peroxide, 2,4-dichlorobenzoyl peroxide, 3,5,5-trimethylhexanoyl peroxide, octanoyl peroxide, lauroyl peroxide, stearoyl peroxide, succinic peroxide, benzoylperoxytoluene, and benzoyl peroxide.
Examples of the peroxy ester include cumyl peroxy neodecanoate, 1,1,3,3-tetramethylbutyl peroxy neodecanoate, 1-cyclohexyl-1-methylethyl peroxy neodecanoate, t-hexyl peroxy neodecanoate, t-amyl peroxy pivalate, t-butyl peroxy pivalate, 1,1,3,3-tetramethylbutyl peroxy-2-ethylhexanoate, 2,5-dimethyl-2,5-bis(2-ethylhexanoylperoxy)hexane, 1-cyclohexyl-1-methylethyl peroxy-2-ethylhexanoate, t-hexyl peroxy-2-ethylhexanoate, t-butyl peroxy-2-ethylhexanoate, t-butylperoxy isobutyrate, 1,1-bis(t-butylperoxy)cyclohexane, t-hexylperoxy isopropyl monocarbonate, t-butylperoxy-3,5,5-trimethylhexanoate, t-butylperoxy laurate, 2,5-dimethyl-2,5-bis(m-toluoylperoxy)hexane, t-butylperoxy isopropyl monocarbonate, t-butylperoxy-2-ethylhexyl monocarbonate, t-hexylperoxybenzoate, t-butylperoxyacetate, t-butylperoxydiethylacetate, and bis(t-butylperoxy)hexahydroterephthalate.
Examples of the dialkyl peroxide include $\alpha$, $\alpha$'-bis(t-butylperoxy)diisopropylbenzene, dicumyl peroxide, 2,5-dimethyl-2,5-bis(t-butylperoxy)hexane, and t-butylcumyl peroxide.
Examples of the percarbonate include di-n-propyl peroxydicarbonate, diisopropyl peroxydicarbonate, bis(4-t-butylcyclohexyl)peroxydicarbonate, di-2-ethoxymethoxyperoxydicarbonate, bis(2-ethylhexylperoxy)dicarbonate, dimethoxybutylperoxydicarbonate, bis(3-methyl-3-methoxybutylperoxy)dicarbonate, and 1,6-di(t-butylperoxycarbonyloxy)hexane.
Examples of the peroxyketal include 1,1-di(t-butylperoxy)cyclohexane and 2,2-bis[4,4-di(t-butylperoxy)cyclohexyl]propane.
Examples of the hydroperoxide include diisopropylbenzene hydroperoxide, 1,1,3,3-tetramethylbutyl hydroperoxide, cumyl hydroperoxide, t-butyl hydroperoxide, and t-amyl hydroperoxide.
Examples of the ketone peroxide include methyl ethyl ketone peroxide and acetylacetone peroxide.
The amount of organic peroxide of the component (C) added is 0.01 to 20 parts by mass, preferably 0.05 to 10 parts by mass, based on 100 parts by mass of the total amount of organopolysiloxane of component (A). The amount added of 0.01 parts by mass or more allows the reaction to proceed sufficiently, to be able to obtain the desired cured product more reliably. The amount added of 20 parts by mass or less prevents the resin from being foamed upon curing.

[Component (D)]

Component (D) is a radically activated hydrosilylation reaction catalyst that exhibits catalytic activity through an action with a radical generated by thermal decomposition of component (C), resulting in having an effect of promoting an addition reaction between an alkenyl group in component (A) and a Si-H group in component (B).
The radically activated hydrosilylation reaction catalyst mainly falls under a platinum group-based metal catalyst or an iron group-based metal catalyst. Example of the platinum group-based metal catalysts include platinum-based, palladium-based, and rhodium-based metal complexes, while examples of the iron group-based metal catalyst include nickel-based, iron-based, and cobalt-based, iron group-based complexes. Among these, the platinum-based metal complex is preferred and often used because it is relatively available and exhibits favorable catalytic activity.
Examples of the catalyst ligand include, from the viewpoint of obtaining long-term storage stability at room temperature, a cyclic diene ligand and a $\beta$-diketonato ligand.
From all those described above, a preferred example of the radically activated hydrosilylation reaction catalyst includes, as a cyclic diene ligand type, a ($\eta^5$-cyclopentadienyl)tri($\sigma$-alkyl)platinum(IV) complex, and specific examples thereof particularly include (methylcyclopentadienyl)trimethylplatinum(IV), (cyclopentadienyl)trimethylplatinum(IV), (1,2,3,4,5-pentamethylcyclopentadienyl)trimethylplatinum(IV), (cyclopentadienyl)dimethylethylplatinum(IV), (cyclopentadienyl)dimethylacetylplatinum(IV), (trimethylsilylcyclopentadienyl)trimethylplatinum(IV), (methoxycarbonylcyclopentadienyl)trimethylplatinum(IV), and (dimethylphenylsilylcyclopentadienyl)trimethylplatinum(I V), and an example of the $\beta$-diketonato ligand type includes a $\beta$-diketonato platinum (II) or platinum (IV) complex, and specific example thereof particularly include trimethyl(acetylacetonato) platinum (IV), trimethyl(3,5-heptanedionato) platinum (IV), trimethyl(methylacetoacetate) platinum (IV), bis(2,4-pentanedionato) platinum (II), bis(2,4-hexanedionato) platinum (II), bis(2,4-heptanedionato) platinum (II), bis(3,5-heptanedionato) platinum (II), bis(1-phenyl-1,3-butanedionato) platinum (II), bis(1,3-diphenyl-1,3-propanedionato) platinum (II), and bis(hexafluoroacetylacetonato) platinum (II).

In using these catalysts, when they are solid catalysts, they can be used in solid form, but in order to obtain a more uniform cured product, it is preferable to dissolve each in a suitable solvent and then use it by compatibilizing it in the organopolysiloxane of component (A), having an alkenyl group. Examples of the solvent include isononane, n-decane, toluene, and 2-(2-butoxyethoxy)ethyl acetate.

The amount of component (D) added may be any effective amount, but it is usually 0.1 to 5,000 ppm as a platinum content (in terms of metal atom amount) based on the total mass of (A) and (B), and preferably 0.5 to 2,000 ppm, and more preferably 1 to 500 ppm. The amount added of 0.1 ppm or more does not deteriorate the curability of the composition, does not reduce the crosslink density and the physical strength of the material. The amount added of 5,000 ppm or less can inhibit the resin from being foamed upon curing.

[Component (E)]

The thermosetting silicone resin composition may further contain a non-functional organopolysiloxane as component (E). Herein, the term "non-functional" means that component (E) has no reactive group such as a hydrogen atom, a halogen atom, a hydroxy group, or an alkoxy group, which is directly bonded to a silicon atom in the molecule, and has no reactive group such as an alkenyl group or an epoxy group, bonded to a silicon atom directly or via an arbitrary group.

An example of such a non-functional organopolysiloxane includes an organopolysiloxane having a monovalent hydrocarbon group other than an aliphatic unsaturated hydrocarbon group, which is unsubstituted or substituted and has 1 to 12 carbon atoms, preferably 1 to 10 carbon atoms. Examples of such a monovalent hydrocarbon group include alkyl groups such as a methyl group, an ethyl group, a propyl group, a butyl group, a pentyl group, a hexyl group, and a heptyl group; a cycloalkyl group such as a cyclohexyl group; aryl groups such as a phenyl group, a tolyl group, a xylyl group, and a naphthyl group; and aralkyl groups such as a benzyl group and a phenethyl group. Also, a hydrogen atom in these groups may be partially or all substituted with a halogen atom such as a chlorine atom, a fluorine atom, or a bromine atom, and examples of such groups include halogenated alkyl groups such as a chloromethyl group, a 3-chloropropyl group, and a 3,3,3-trifluoropropyl group. The monovalent hydrocarbon group is preferably an alkyl group or an aryl group and more preferably a methyl group or a phenyl group.

The molecular structure of the non-functional organopolysiloxane of component (E) is not particularly limited and may be linear, branched, cyclic, or the like, however, a linear or branched organopolysiloxane is preferred, and a linear diorganopolysiloxane in which the main chain is basically composed of a diorganosiloxane repeating unit and both ends of the molecular chain are blocked with triorganosiloxy groups is preferred.

The 30% by mass toluene solution of the non-functional organopolysiloxane of component (E) preferably has a viscosity (25°C) of 100 to 500,000 mPa·s and more preferably 5,000 to 500,000 mPa·s, from the viewpoint of workability of the composition, coatability to a substrate, the mechanical properties of a cured product, and peelability of a support. Within such a range of the viscosity, the non-functional organopolysiloxane has an appropriate molecular weight, as a result of which when the silicone resin composition is heated and cured, it does not volatilize, making it less likely not to obtain the desired effect, and does not cause a wafer to crack in wafer thermal process such as CVD, and has favorable workability and coatability, which is preferred.

Examples of the non-functional organopolysiloxane include a dimethylsiloxane polymer blocked with trimethylsiloxy groups at both ends of the molecular chain, a phenylmethylpolysiloxane blocked with trimethylsiloxy groups at both ends of the molecular chain, a 3,3,3 trifluoropropylmethylsiloxane polymer blocked with trimethylsiloxy groups at both ends of the molecular chain, a dimethylsiloxane·methylphenylsiloxane copolymer blocked with trimethylsiloxy groups at both ends of the molecular chain, a dimethylsiloxane·3,3,3-trifluoropropylmethyl copolymer blocked with trimethylsiloxy groups at both ends of the molecular chain, a methylphenylsiloxane·3,3,3-trifluoropropylmethyl copolymer blocked with trimethylsiloxy groups at both ends of the molecular chain, a dimethylsiloxane·3,3,3-trifluoropropylmethylsiloxane·-methylphenylsiloxane copolymer blocked with trimethylsiloxy groups at both ends of the molecular chain, a dimethylpolysiloxane blocked with dimethylphenylsiloxy groups at both ends of the molecular chain, a methylphenylpolysiloxane blocked with dimethylphenylsiloxy groups at both ends of the molecular chain, and a dimethylsiloxane·methylphenylsiloxane copolymer blocked with dimethylphenylsiloxy groups at both ends of the molecular chain.

The non-functional organopolysiloxane of component (E) may be used singly or in combination of two or more thereof. Also, the properties thereof are preferably oily or rubbery.

The component (E) is preferably compounded in an amount of 0.1 to 200 parts by mass and more preferably 1 to 100 parts by mass, based on 100 parts by mass of component (A). The compounding ratio of 0.1 parts by mass or more allows a support to be easily peeled off in the step of peeling off the support from the substrate, which is preferred. Furthermore, the compounding ratio of 200 parts by mass or less results in wafer processing durability without peeling of

wafer upon wafer processing such as wafer back surface grinding and subsequent heat treatment, which is preferred.

[Component (F)]

The thermosetting silicone resin composition may further contain a reaction control agent (hydrosilylation reaction control agent) as component (F). The reaction control agent is optionally added, if necessary, in order to prevent the composition from increasing a viscosity or causing gelation when the composition is prepared, applied to a substrate by coating, or stored.

Examples of the reaction control agent include 3-methyl-1-butyn-3-ol, 3-methyl-1-pentyn-3-ol, 3,5-dimethyl-1-hexyn-3-ol, 1-ethynylcyclohexanol, 3-methyl-3-trimethylsiloxy-1-butyne, 3-methyl-3-trimethylsiloxy-1-pentyne, 3,5-dimethyl-3-trimethylsiloxy-1-hexyne, 1-ethynyl-1-trimethylsiloxycyclohexane, bis(2,2-dimethyl-3-butynyloxy)dimethylsilane, 1,3,5,7-tetramethyl-1,3,5,7-tetravinylcyclotetrasiloxane, and 1,1,3,3-tetramethyl-1,3-divinyldisiloxane. Among these, 1-ethynylcyclohexanol and 3-methyl-1-butyn-3-ol are preferred.

When the thermosetting silicone resin composition contains the component (F), the content thereof should be adjusted to an optimum amount because its control ability differs depending on the chemical structure, however, taking into consideration the effects on curability, storage stability, and physical properties after curing, the content of component (F) is preferably 0.001 to 10 parts by mass and more preferably 0.01 to 10 parts by mass, based on the total mass of the components (A) and (B). The content of the component (F) within the above range results in prolonged usable time, long-term storage stability, and favorable curability and workability of the composition.

In the thermosetting silicone resin composition, an organopolysiloxane that includes a $R^A{}_3SiO_{0.5}$ unit (wherein, $R^A$ is each independently an unsubstituted or substituted monovalent hydrocarbon group having 1 to 10 carbon atoms) and a $SiO_2$ unit, and has a mole ratio of the $R^A{}_3SiO_{0.5}$ unit to the $SiO_2$ unit ($R^A{}_3SiO_{0.3}/SiO_2$) of 0.3 to 1.8, may be further included. The amount of organopolysiloxane added is preferably 0 to 500 parts by mass based on 100 parts by mass of component (A).

In the thermosetting silicone resin composition, a filler such as silica may be included in order to further improve heat resistance of a temporary adhesive layer to be obtained from the composition.

The thermosetting silicone resin composition may be used in solution form by adding a solvent to the composition, for reasons such as improvement on workability and mixability, resulting from having reduced the viscosity of the composition, adjustment of film thickness of the temporary adhesive layer, and the like. The solvent to be used is not particularly limited as long as it can dissolve the above components, but for example, hydrocarbon solvents such as pentane, hexane, cyclohexane, isooctane, nonane, decane, p-menthane, pinene, isododecane, and limonene are preferred.

Examples of the method of forming a solution includes a method for preparing the thermosetting silicone resin composition and finally adding a solvent to adjust the viscosity to the desired level, and a method for preliminarily diluting highly viscous (A) with a solvent to improve workability and mixability, and then mixing the remaining component. Also, a mixing method in forming a solution may be appropriately selected from mixing means such as a shaking mixer, a magnetic stirrer, and various mixers, based on the viscosity and workability of the composition, to then carry it out.

The amount of solvent compounded may be appropriately set from the viewpoint of adjusting the viscosity of the composition and workability, a film thickness of the temporary adhesive layer, and the like, but for example, it is preferably 5 to 900 parts by mass and more preferably 10 to 400 parts by mass, based on 100 parts by mass of the thermosetting silicone resin composition.

The temporary adhesive layer can be formed by coating a surface of a substrate with the thermosetting silicone resin composition by a method such as spin-coating or roll coating. Of these, when forming the temporary adhesive layer on a substrate by a method such as spin-coating, it is preferable to coat the substrate with the thermosetting silicone resin composition in solution form.

From the viewpoint of coatability, the viscosity at 25°C of the thermosetting silicone resin composition in solution form is preferably 1 to 100,000 mPa·s and more preferably 10 to 10,000 mPa·s.

The thermosetting silicone resin composition usually has a 180° peel strength at 25°C after curing of 10 to 500 gf, preferably 20 to 400 gf, and more preferably 30 to 300 gf, when a test specimen with a width of 25 mm (for example, a glassy test specimen) is peeled off, and the 180° peel strength of 10 gf or more makes it unlikely for a wafer to have a risk of being misaligned upon wafer grinding, and the 180° peel strength of 500 gf or less facilitates a wafer to be peeled off.

The thermosetting silicone resin composition has a storage modulus at 25°C after curing of 1,000 Pa or more and 1,000 MPa or less and preferably 10,000 Pa or more and 100 MPa or less. When the storage modulus is 1,000 Pa or more, the film to be formed will be robust, causing no risk of misalignment of wafer upon wafer grinding or wafer cracks accompanying the misalignment, and the deforming stress of 1,000 MPa or less can reduce the deforming stress during a wafer thermal process such as CVD and provides stability upon thermal process of wafers.

The radically activated hydrosilylation reaction catalyst of component (D) to be used in the thermosetting silicone resin composition also has ultraviolet-ray activity, and therefore it is preferable to store the resin composition in a cool, dark

place when stored. It is also preferable to use a light-shielding container for filling. This makes it possible to provide stable properties over a long period of time that are the same as those immediately after production, whereas the composition does not increase its viscosity or is not cured even during long-term storage.

The present invention provides a wafer laminate using the temporary adhesive for wafer processing as described above. That is, the wafer laminate of the present invention is a wafer laminate including a support, a temporary adhesive layer obtained from the temporary adhesive for wafer processing described above, stacked on the support, and a wafer having a circuit-forming surface on a front surface and a circuit-free surface on a back surface, wherein the temporary adhesive layer is peelably adhered to the front surface of the wafer.

[Method for producing thin wafer]

The method for producing a thin wafer of the present invention is characterized in that for temporary adhesion between a wafer having a semiconductor circuit or the like and a support, a temporary adhesive for wafer processing used is composed of the thermosetting silicone resin composition.

The method for producing a thin wafer of the present invention includes the following steps (a) to (e).

[Step (a)]

The step (a) is a temporary adhesion step of allowing a circuit-forming surface of a wafer having the circuit-forming surface on its front surface and a circuit-free surface on its back surface to peelably adhere to a support using the temporary adhesive for wafer processing to form a wafer laminate.

Specifically, temporary adhesion can be performed by using the temporary adhesive for wafer processing to form a temporary adhesive layer on a front surface of the wafer and allowing the support and the front surface of the wafer to be bonded together via the temporary adhesive layer. Alternatively, temporary adhesion can be performed by using the temporary adhesive for wafer processing to form a temporary adhesive layer on a surface of the support, and allowing the support and the front surface of the wafer to be bonded together via the temporary adhesive layer.

A wafer applicable to the present invention is usually a semiconductor wafer. Examples of the semiconductor wafer include not only a silicon wafer but also a germanium wafer, a gallium-arsenide wafer, a gallium-phosphorus wafer, and a gallium-arsenide-aluminum wafer. A thickness of the wafer is not particularly limited, but is typically 600 to 800 μm and more typically 625 to 775 μm.

The support that is a substrate such as a silicon wafer, a glass plate, or a quartz wafer can be used, but is not limited thereto. In the present invention, it is not necessary to irradiate the temporary adhesive layer with radiant energy rays through a support, and therefore the support may not be light transmittable.

The temporary adhesive layer may be formed by stacking the thermosetting silicone resin composition formed into a film on a wafer or a support, or may be formed by being coated with the thermosetting silicone resin composition by a method such as spin-coating or roll coating. In a case in which the thermosetting silicone resin composition is a solution containing a solvent, following coating, it is prebaked at a temperature of preferably 40 to 200°C and more preferably 50 to 150°C, depending on the volatilization conditions of the solvent, and then used.

The temporary adhesive layer is preferably formed to a film thickness of 0.1 to 500 μm, preferably 1.0 to 200 μm, and then used. The film thickness of the layer of 0.1 μm or more, when a surface of a support is coated therewith, allows the layer to be coated on the entire substrate without leaving any uncoated areas. The temporary adhesive layer with a film thickness of 500 μm or less, on the other hand, can withstand the grinding process when forming a thin wafer.

An example of the method for allowing the support and the front surface of the wafer to be bonded together via the temporary adhesive layer includes a method of uniform pressure bonding under reduced pressure at a temperature range of preferably 40 to 200°C and more preferably 50 to 150°C.

The pressure when a wafer on which the temporary adhesive layer has been formed and the support undergo pressure bonding is preferably 0.01 to 10 MPa and more preferably 0.1 to 1.0 MPa, depending on the viscosity of the temporary adhesive layer. The pressure of 0.01 MPa or more allows a circuit-forming surface and a space between a wafer and a support to be filled with the temporary adhesive layer, and the pressure of 10 MPa or less causes no risk of wafer cracking or deterioration of flatness of a wafer and the temporary adhesive layer, resulting in favorable subsequent wafer processing.

The wafers can be bonded together using a commercially available wafer bonder, such as EVG520IS or 850TB, manufactured by EVG Corporation or XBS300 manufactured by SUSS MicroTec SE.

[Step (b)]

The step (b) is a step of thermally curing the temporary adhesive layer. After having formed the wafer laminate, the temporary adhesive layer is cured by heating at preferably 50 to 300°C and more preferably 100 to 200°C, for preferably 1

minute to 4 hours and more preferably 5 minutes to 2 hours.

[Step (c)]

The step (c) is a step of grinding or polishing a circuit-free surface of a wafer that has temporarily adhered to a support, that is, the step of grinding a back surface side of a wafer of the wafer laminate obtained in the above step to make the wafer thin. The method for grinding the back surface of the wafer is not particularly limited, and a publicly known grinding method is adopted. Grinding is preferably performed while spraying water on a wafer and grinding wheel (diamond or the like). An example of an apparatus for grinding a back surface of a wafer includes a DAG-810 (product name) manufactured by Disco Corporation. The back surface side of the wafer may also be subjected to chemical mechanical polishing (CMP).

[Step (d)]

The step (d) is a step of subjecting a circuit-free surface of a wafer laminate in which the circuit-free surface has been ground in the step (c) to processing. In other words, it is the step of subjecting a circuit-free surface of a wafer laminate that has been made thin by back surface grinding to processing. This step includes various processes to be used at wafer level. Examples thereof include electrode formation, metal wiring formation, and protective film formation. More specific examples thereof include conventionally publicly known processes such as metal sputtering for forming an electrode and the like, wet etching for etching a metal sputtered layer, coating with a resist to serve as a mask for forming a metal wiring, light exposure, and development to form a pattern, resist stripping, dry etching, forming of metal plating, silicon etching for forming a TSV, and forming of oxide film on a silicon surface.

[Step (e)]

The step (e) is a step of peeling off the wafer subjected to the processing in step (d) from a support, that is, a step of peeling off the wafer from the support after various processing has been performed on a thinned wafer and before dicing. This peeling step is generally performed under relatively mild conditions from room temperature to approximately 60°C. Examples of the peeling method include a method for horizontally fixing one side of a wafer or a support of a wafer laminate and lifting the other side at a certain angle for the horizontal direction, and a method for attaching a protective film on a ground surface of a wafer that has been ground and peeling off the wafer and the protective film from the wafer laminate in a peeling manner. When the peeling step is performed by these peeling manners, it is usually performed at room temperature.

Also step (e) preferably includes

step (e1) of attaching a dicing tape to a wafer surface of a processed wafer;
step (e2) of vacuum-adsorbing a surface of the dicing tape to an adsorption surface; and
step (e3) of peeling off the support from the processed wafer in a peel-off manner at a temperature of the adsorption surface in the range of 10 to 100°C. In this manner, the support can be easily peeled off from the processed wafer, and the subsequent dicing step can be easily performed.

Furthermore, following step (e),
step (f) of removing the temporary adhesive layer remaining on a circuit-forming surface of the peeled wafer, is preferably carried out. The temporary adhesive layer may partially remain on the circuit-forming surface of the wafer peeled off from the support in step (e), and the temporary adhesive layer can be removed, for example, by cleaning the wafer.

In this step (f), any cleaning liquid that dissolves the silicone resin of the temporary adhesive layer can be used, and specific examples thereof include pentane, hexane, cyclohexane, decane, isononane, p-menthane, pinene, isododecane, and limonene. These solvents may be used singly or in combination of two or more thereof.

When the temporary adhesive layer is difficult to remove, bases or acids may be added to the cleaning liquid. The bases including amines such as ethanolamine, diethanolamine, triethanolamine, triethylamine, and ammonia; and ammonium salts such as tetramethylammonium hydroxide, can be used. The acids that are organic acids such as acetic acid, oxalic acid, benzenesulfonic acid, and dodecylbenzenesulfonic acid can be used. The amount of base or acid added is such that the concentration in the cleaning liquid is preferably 0.01 to 10% by mass and more preferably 0.1 to 5% by mass. Also, an existing surfactant may be added to improve the removability of the remaining matter. Furthermore, the SPIS-TA-CLEANER series (manufactured by Shin-Etsu Chemical Co., Ltd.), which is available as a wafer cleaning agent, may also be suitably used.

Examples of the wafer cleaning method include a method of cleaning with a paddle using the cleaning liquid, a method of cleaning by spraying, and a method of immersing in a cleaning liquid tank. A temperature upon cleaning is

preferably 10 to 80°C and more preferably 15 to 65°C. After having dissolved the temporary adhesive layer with these cleaning liquids, a final rinse with water or alcohol may be performed followed by drying treatment, if necessary.

The thickness of the thin wafer obtained by the production method of the present invention is typically 5 to 300 μm and more typically 10 to 100 μm.

EXAMPLE

The present invention will be described in more detail below with reference to Preparation Examples, Comparative Preparation Examples, Examples, and Comparative Examples, but the present invention is not limited to these Examples. It is to be noted that the viscosity is a value measured at 25°C using a rotational viscometer.

[1] Preparation of thermosetting silicone resin solution [Preparation Example 1]

To a solution of 100 parts by mass of dimethylpolysiloxane having an Mn of 30,000 and consisting of 97.5 mol% of a $(CH_3)_2SiO_{2/2}$ unit (D unit) and 2.5 mol% of a $(CH_2=CH)(CH_3)SiO_{2/2}$ unit ($D^{Vi}$ unit) and 200 parts by mass of toluene, were added 50 parts by mass of vinylmethylpolysiloxane having an Mn of 7,000 and a resin structure consisting of 50 mol% of a $SiO_{4/2}$ unit (Q unit), 48 mol% of $(CH_3)_3SiO_{1/2}$ unit (M unit), and 2 mol% of $(CH_2=CH)(CH_3)_2SiO_{1/2}$ unit ($M^{Vi}$ unit) and 100 parts by mass of toluene, 21 parts by mass of an organohydrogenpolysiloxane having an Mn of 2,400 and consisting of 83.9 mol% of a $(CH_3)_2SiO_{2/2}$ unit (D unit) and 16.1 mol% of a $(CH_3)_2HSiO_{2/2}$ unit ($D^H$ unit), 50 parts by mass of dimethylpolysiloxane blocked with trimethylsiloxy groups at both ends of the molecular chain, wherein a 30% by mass toluene solution thereof has a viscosity (25°C) of 30,000 mPa·s, and 120 parts by mass of toluene, as well as 0.6 parts by mass of 1-ethynylcyclohexanol, and the mixture was mixed. Furthermore, 0.4 parts by mass of a toluene solution of a radically activated hydrosilylation reaction catalyst: (methylcyclopentadienyl)trimethylplatinum (IV) (platinum concentration: 1.0% by mass) and 0.1 parts by mass of 1,6-di(t-butylperoxycarbonyloxy)hexane (product name: Kayalen 6-70, 10-hour half-life temperature: 97°C, 1-minute half-life temperature: 150°C, manufactured by Kayaku Nouryon Corporation) were added thereto, and the mixture was filtered through a 0.2 μm membrane filter to prepare a thermosetting silicone resin solution A1. It is to be noted that the half-life temperature of the organic peroxide is a half-life during which the organic peroxide has been decomposed by heat and the amount of active oxygen therein is reduced to half the amount before the decomposition, and the half-life was determined by preparing a benzene solution of the organic peroxide with a concentration of 0.1 mol/L and measuring a change over time in organic peroxide concentration when the solution was thermally decomposed. The viscosity of resin solution A1 at 25°C was 2,300 Pa·s.

The value of the total of the SiH groups in component (B) to the total of the alkenyl groups in component (A) (Si-H/Si-Vi) in this Preparation Example 1 is calculated using the following formula:

(1) Amount of Si-Vi from PDMS (mol)

(amount of PDMS added/PDMS molecular weight) × <PDMS molecular weight/{[(D unit molecular weight) × (D unit mol%/100)] + [($D^{Vi}$ unit molecular weight) × ($D^{vi}$ unit mol%/100)]}> × ($D^{vi}$ unit mol%/100)

(2) Amount of Si-Vi from PVMS of resin structure with Vi group (mol)

(amount of PVMS added/PVMS molecular weight) × <PVMS molecular weight/{[(Q unit molecular weight) × (Q unit mol%/100)] + [(M unit molecular weight) × (M unit mol%/100)] + [($M^{Vi}$ unit molecular weight) × ($M^{Vi}$ unit mol %/100)]}> × ($M^{Vi}$ unit mol%/100)

(3) Amount of Si-H from POHS (mol)

(amount of POHS added/POHS molecular weight) × <PVMS molecular weight/{[(D unit molecular weight) × (D unit mol%/100)] + [($D^H$ unit molecular weight) × ($D^H$ unit mol%/100)]}> × ($D^H$ unit mol%/100)

(in the above-described formulae, PDMS:
dimethylpolysiloxane, PVMS: vinylmethylpolysiloxane having a resin structure, POHS:
organohydrogenpolysiloxane).

The Si-H/Si-Vi (mole ratio) in Preparation Example 1 obtained from (1) to (3) above is 1.0.

[Preparation Example 2]

To a solution of 70 parts by mass of dimethylpolysiloxane having an Mn of 30,000 and consisting of 97.5 mol% of a $(CH_3)_2SiO_{2/2}$ unit (D unit) and 2.5 mol% of a $(CH_2{=}CH)(CH_3)SiO_{2/2}$ unit ($D^{Vi}$ unit), 30 parts by mass of dimethylpolysiloxane having an Mn of 60,000 and consisting of 99.85 mol% of a $(CH_3)_2SiO_{2/2}$ unit (D unit) and 0.15 mol% of a $(CH_2{=}CH)(CH_3)SiO_{2/2}$ unit ($D^{Vi}$ unit), and 200 parts of toluene, were added 50 parts by mass of vinylmethylpolysiloxane having an Mn of 7,000 and a resin structure consisting of 50 mol% of a $SiO_{4/2}$ unit (Q unit), 48 mol% of $(CH_3)_3SiO_{1/2}$ unit (M unit), and 2 mol% of $(CH_2{=}CH)(CH_3)_2SiO_{1/2}$ unit ($M^{Vi}$ unit) and 100 parts by mass of toluene, 25 parts by mass of an organohydrogenpolysiloxane having an Mn of 2,400 and consisting of 83.9 mol% of a $(CH_3)_2SiO_{2/2}$ unit (D unit) and 16.1 mol% of a $(CH_3)_2HSiO_{2/2}$ unit ($D^H$ unit), 30 parts by mass of dimethylpolysiloxane blocked with trimethylsiloxy groups at both ends of the molecular chain, wherein a 30% by mass toluene solution thereof has a viscosity (25°C) of 5,000 mPa·s, and 30 parts by mass of toluene as well as 0.6 parts by mass of 1-ethynylcyclohexanol, and the mixture was mixed. Furthermore, 0.4 parts by mass of a toluene solution of a radically activated hydrosilylation reaction catalyst: (methylcyclopentadienyl) trimethylplatinum (IV) (platinum concentration: 1.0% by mass) and 0.07 parts by mass of t-butylperoxy-2-ethylhexyl monocarbonate (product name: Trigonox (R) 117, 10-hour half-life temperature: 98°C and 1-minute half-life temperature: 156°C, manufactured by Kayaku Nouryon Corporation) were added thereto, and the mixture was filtered through a 0.2 μm membrane filter to prepare thermosetting silicone resin solution A2. The viscosity of resin solution A2 at 25°C was 1,800 mPa·s. Also, the Si-H/Si-Vi (mole ratio) in Preparation Example 2 is 1.5.

[Preparation Example 3]

Thermosetting silicone resin solution A3 was prepared in the same manner as in Preparation Example 1 above, except that 0.4 parts by mass of the toluene solution of the radically activated hydrosilylation reaction catalyst: methylcyclopentadienyl)trimethylplatinum (IV) to be used (platinum concentration: 1.0% by mass) was changed to 0.8 parts by mass of a 2-(2-butoxyethoxy)ethyl acetate solution of bis(2,4-heptanedionato)platinum (II) (platinum concentration: 0.5% by mass), and the amount of organohydrogenpolysiloxane having an Mn of 2,400 and consisting of 83.9 mol% of a $(CH_3)_2SiO_{2/2}$ unit (D unit) and 16.1 mol% of a $(CH_3)_2HSiO_{2/2}$ unit ($D^H$ unit) added was changed to 15 parts by mass. The viscosity of resin solution A3 at 25°C was 2,200 mPa·s. Also, the Si-H/Si-Vi (mole ratio) in Preparation Example 3 is 0.7.

[Preparation Example 4]

Thermosetting silicone resin solution A4 was prepared in the same manner as in Preparation Example 2 above, except that 0.4 parts by mass of the toluene solution of the radically activated hydrosilylation reaction catalyst: (methylcyclopentadienyl)trimethylplatinum (IV) to be used (platinum concentration: 1.0% by mass) was changed to 0.8 parts by mass of a 2-(2-butoxyethoxy)ethyl acetate solution of bis(2,4-heptanedionato)platinum(II) (platinum concentration: 0.5% by mass), and the amount of organohydrogenpolysiloxane having an Mn of 2,400 and consisting of 83.9 mol% of a $(CH_3)_2SiO_{2/2}$ unit (D unit) and 16.1 mol% of a $(CH_3)_2HSiO_{2/2}$ unit ($D^H$ unit) added was changed to 21 parts by mass. The viscosity of resin solution A4 at 25°C was 1,900 mPa·s. Also, the Si-H/Si-Vi (mole ratio) in Preparation Example 4 is 1.2.

[Comparative Preparation Example 1]

In the Preparation Example 1 described above, instead of having added 0.4 parts by mass of the toluene solution of (methylcyclopentadienyl)trimethylplatinum (IV) (platinum concentration: 1.0% by mass) and 0.1 parts by mass of 1,6-di(t-butylperoxycarbonyloxy)hexane, 0.4 parts by mass of a hydrosilylation reaction catalyst CAT-PL-5 (platinum concentration: 1.0% by mass, manufactured by Shin-Etsu Chemical Co., Ltd.) was added, and the mixture was filtered through a 0.2 μm membrane filter to prepare thermosetting silicone resin solution C1. The viscosity of resin solution C1 at 25°C was 2,300 mPa·s. Also, the Si-H/Si-Vi (mole ratio) in Comparative Preparation Example 1 is 1.0.

[Comparative Preparation Example 2]

In the Preparation Example 2 described above, instead of having added 0.4 parts by mass of the toluene solution of (methylcyclopentadienyl)trimethylplatinum (IV) (platinum concentration: 1.0% by mass) and 0.07 parts by mass of t-butylperoxy-2-ethylhexyl monocarbonate, 0.4 parts by mass of a hydrosilylation reaction catalyst CAT-PL-5 (platinum concentration: 1.0% by mass, manufactured by Shin-Etsu Chemical Co., Ltd.) was added, and the mixture was filtered through a 0.2 μm membrane filter to prepare thermosetting silicone resin solution C2. The viscosity of resin solution C2 at 25°C was 1,900 mPa·s. Also, the Si-H/Si-Vi (mole ratio) in this Comparative Preparation Example 2 is 1.2.

[2] Evaluation of storage stability of thermosetting silicone resin solution

[Examples 1 to 4 and Comparative Examples 1 and 2]

A surface of a silicon substrate was coated with each of (1) the thermosetting silicone resin solutions obtained in Preparation Examples 1 to 4 and Comparative Preparation Examples 1 and 2 immediately after the preparation and (2) those stored at 50°C for one month in a light-shielded, sealed environment, and the thickness of the film upon coating on the silicon substrate was measured. It is to be noted that the silicon substrate used was a silicon wafer with a diameter of 200 mm and a thickness of 725 μm, and thermosetting silicone resin solutions A1 to A4, C1, and C2 were each spin-coated, and the coated wafer was heated on a hot plate at 100°C for 2 minutes and then at 180°C for 30 minutes to fabricate a silicone resin cured film on the silicon wafer. Also, the thickness of the cured film was measured using a F50 manufactured by Filmetrics Corporation. The results are shown in Table 1.

[Table 1]

| | | Example 1 | Example 2 | Example 3 | Example 4 | Comparative Example 1 | Comparative Example 2 |
|---|---|---|---|---|---|---|---|
| Thermosetting silicone resin solution | | A1 | A2 | A3 | A4 | C1 | C2 |
| Film thickness of temporary adhesive layer (μm) | When initially prepared | 60 | 55 | 58 | 59 | 61 | 58 |
| | After 50°C x 1 month | 62 | 58 | 62 | 62 | 72 | 81 |

The results in Table 1 confirmed that the present Examples inhibited the initial film thickness from being changed in the solution after storage compared to Comparative Examples using the conventional platinum addition cure-based resin composition. From this result, it was confirmed that the thermosetting silicone resin solution of the present Example has excellent long-term storage stability.

[3] Fabrication and evaluation of wafer laminate [Examples 5 to 9, Comparative Examples 3 to 5, and Reference Example]

A 200 mm-diameter silicon wafer (thickness: 725 μm) with copper posts of 10 μm height and 40 μm diameter formed on the entire front surface, which was also coated with each of a "PI film," a "SiN film," and a "PBO film," was spin-coated with each of thermosetting silicone resin solutions A1 to A4 and C1 and C2, and the coated wafer was heated in an oven at 100°C for 2 minutes in air, to form a temporary adhesive layer on the bump-forming surface of the wafer with each film thickness shown in Tables 2 and 3 below. With a glass plate having a diameter of 200 mm (thickness: 500 μm) as a support, the silicon wafer coated with the temporary adhesive layer and the glass plate were vacuum bonded to each other at 100°C, $10^{-3}$ mbar or less under a load of 5 kN, using a wafer bonder EVG520IS manufactured by EVG Corporation so that the temporary adhesive layer and the glass plate were aligned, to fabricate a wafer laminate. It is to be noted that the glass plate was used as the support in order to visually check for abnormalities after adhesion of the substrate, however, a silicon substrate that does not transmit light, such as a wafer, can also be used. Also, in order to more clarify that the results of this Comparative Example are attributable to the influence of the organic resin film on the wafer, a wafer without being coated with the organic resin film was used to evaluate the C1 solution prepared in Comparative Preparation Example 1 in the same manner as above, which was used as Reference Example.

Thereafter, the following tests were carried out on the wafer laminates obtained. The results are shown in Tables 2 and 3. The tests were carried out by the following method.

(1) Adhesion test

The wafer laminate was heated in an oven at 180°C for 1 hour, and then cooled to room temperature, and an adhesion state at a wafer interface was visually confirmed. In the case of no abnormalities such as air bubbles occurred at the interface, it was evaluated and rated as favorable and indicated with "O", and when abnormalities occurred, it was evaluated and rated as poor and indicated with "×".

(2) Back surface grinding resistance test

Using the wafer laminate, the back surface of the silicon wafer was ground using a diamond grinding wheel on a

grinder (DAG-810, manufactured by Disco Corporation). After having ground the substrate to a thickness of 50 μm, the presence or absence of abnormalities such as cracks and peeling was checked with an optical microscope (100-times magnification). No abnormalities occurred was evaluated and rated as favorable and indicated with "O", and an abnormality occurred was evaluated and rated as poor and indicated with "×".

(3) CVD resistance test

The wafer laminate after completion of (2) the back surface grinding resistance test was introduced into a CVD apparatus, and a deposition experiment of 2 μm $SiO_2$ film was conducted. The presence or absence of appearance abnormalities was visually observed to be checked. When no appearance abnormalities occurred, they were evaluated and rated as favorable and indicated with a "O", and when appearance abnormalities such as a void, wafer swelling, or wafer damage occurred, they were evaluated and rated as poor and indicated with "×". The conditions for the CVD resistance test were as follows.

Apparatus name: A Plasma CVD, PD270STL manufactured by Samco Corporation
RF 500W, internal pressure 40Pa,
TEOS (tetraethyl orthosilicate): $O_2$ = 20sccm: 680sccm

(4) Peelability test

The peelability of the substrate was evaluated as follows by, first, attaching a dicing tape (ELP UB-3083D, manufactured by Nitto Denko Corporation) to a wafer side of the wafer laminate after completion of (3) CVD resistance test, using a dicing frame, and setting this dicing tape surface on an adsorption plate by vacuum adsorption. Thereafter, at room temperature, one point of the glass was lifted with tweezers to peel off the glass substrate. In a case in which the wafer of 50 μm thickness could be peeled off without cracking, it was indicated with "O", and when abnormalities such as cracks occurred, it was evaluated and rated as poor and indicated with "×".

(5) Cleanability and removability test

The 200-mm diameter wafer (exposed under the conditions of the CVD resistance test) attached to a dicing frame via the dicing tape after completion of (4) the peelability test, was set on a spin coater with the peeled surface facing up, and sprayed for 5 minutes with a SPIS-TA-CLEANER 27 (manufactured by Shin-Etsu Chemical Co., Ltd.) as a cleaning solvent, and then rinsed by spraying isopropyl alcohol (IPA) under rotation of the wafer. Thereafter, the appearance was observed and the presence or absence of the remaining adhesive was visually checked. When no remaining resin was confirmed, it was evaluated and rated as favorable and indicated with "O", and when the remaining resin was observed, it was evaluated and rated as poor and indicated with "×".

(6) Peel strength test

A 200-mm diameter silicon wafer (thickness: 725 μm), the entire front surface of which was coated with a "PI film", a "SiN film", or a "PBO film", respectively, was spin-coated with thermosetting silicone resin solutions A1 to A4, C1, and C2, respectively, and the coated wafer was heated on a hot plate at 100°C for 2 minutes to form a silicone resin layer on the bump-forming surface of the wafer with the film thickness shown in Table 1. Thereafter, the silicone resin layer was cured in an oven at 180°C for 1 hour, and cooled to room temperature. Then, five pieces of a polyimide tape of 150 mm long × 25 mm wide were attached to the silicone resin layer on the wafer, and the temporary adhesive layer was removed from the areas where no tape was attached. Using an AUTOGRAPH (AG-1) manufactured by Shimadzu Corporation, 120 mm of the tape was peeled off from one end at a speed of 300 mm/min at 25°C in a 180° peel manner, and the average strength applied at that time (120 mm stroke × 5 times) was taken as the peel strength of the silicone resin layer.

(7) Storage modulus measurement

A 200-mm diameter silicon wafer (thickness: 725 μm), the entire front surface of which was coated with a "PI film", a "SiN film", or a "PBO film", respectively, was spin-coated with thermosetting silicone resin solutions A1 to A4, C1, and C2, respectively, and the coated wafer was heated on a hot plate at 100°C for 2 minutes to form a silicone resin layer on a glass substrate with each film thickness shown in Tables 2 and 3. The silicone resin layer was then cured in an oven at 180°C for 1 hour and cooled to room temperature. The glass substrate including the obtained silicone resin layer while being sandwiched between 25 mm aluminum plates so that a load of 50 gf was applied to the silicone resin layer, was subjected to elastic modulus measurement under the conditions of 25°C, 1 Hz, and 1% strain, using an Ares G2 manufactured by TA

Instruments, and the obtained elastic modulus value was taken as the storage modulus of the silicone resin layer.

[Table 2]

| | | Example 5 | Example 6 | Example 7 | Example 8 | Example 9 |
|---|---|---|---|---|---|---|
| Wafer with circuit | Material | Si | Si | Si | Si | Si |
| | Surface coating | PI film | PI film | SiN film | SiN film | PBO film |
| Thermosetting silicone resin solution | | A1 | A3 | A2 | A4 | A1 |
| Film thickness of temporary adhesive layer (μm) | | 60 | 59 | 60 | 61 | 58 |
| Temporary adhesive layer peel strength (gf) | | 90 | 80 | 40 | 50 | 100 |
| Temporary adhesive layer film elastic modulus (x$10^5$Pa) | | 70 | 60 | 20 | 30 | 60 |
| Support | | Glass | Glass | Glass | Glass | Glass |
| Adhesiveness | | ○ | ○ | ○ | ○ | ○ |
| Back surface grinding resistance | | ○ | ○ | ○ | ○ | ○ |
| CVD resistance | | ○ | ○ | ○ | ○ | ○ |
| Peelability | | ○ | ○ | ○ | ○ | ○ |
| Cleaning removability | | ○ | ○ | ○ | ○ | ○ |

[Table 3]

| | | Comparative Example 3 | Comparative Example 4 | Comparative Example 5 | Reference Example |
|---|---|---|---|---|---|
| Wafer with circuit | Material | Si | Si | Si | Si |
| | Surface coating | PI film | SiN film | PBO film | None |
| Thermosetting silicone resin solution | | C1 | C2 | C1 | C2 |
| Film thickness of temporary adhesive layer (μm) | | 61 | 61 | 61 | 60 |
| Temporary adhesive layer peel strength (gf) | | 6 | 7 | 6 | 40 |
| Temporary adhesive layer film elastic modulus (x$10^5$Pa) | | 0.7 | 0.3 | 0.1 | 15 |
| Support | | Glass | Glass | Glass | Glass |
| Adhesiveness | | ○ | ○ | ○ | ○ |
| Back surface grinding resistance | | × After grinding, peeling of the wafer with circuits was confirmed. | × After grinding, peeling of the wafer with circuits was confirmed. | × After grinding, peeling of the wafer with circuits was confirmed. | ○ |
| CVD resistance | | - | - | - | ○ |
| Peelability | | - | - | - | ○ |
| Cleaning removability | | - | - | - | ○ |

As shown in Tables 2 and 3, the wafer laminates of Examples 5 to 9, which included the temporary adhesive layer of the present invention, were confirmed to have sufficient processing durability, facilitation of peel, and excellent residue

cleaning removability on the wafer after being peeled off, even on the wafers with the organic resin coating thereon. The temporary adhesives of Comparative Examples 3 to 5, which used the conventional platinum addition cure-based resin composition, on the other hand, resulted in peeling problems, particularly in wafer processability, due to the influence of the organic resin coating on the wafer.

The present description includes the following embodiments.

[1]: A method for producing a thin wafer using a thermosetting silicone resin composition as a temporary adhesive for wafer processing for allowing a wafer to temporarily adhere to a support,
wherein the thermosetting silicone resin composition can be cured only by heating and comprises the following components:

(A) an organopolysiloxane having two or more alkenyl groups in one molecule in an amount of 100 parts by mass,
(B) an organohydrogenpolysiloxane comprising two or more silicon atom-bonded hydrogen atoms (SiH groups) in one molecule in an amount such that a mole ratio of a total of SiH groups in component (B) to a total of alkenyl groups in component (A) is from 0.3 to 10,
(C) an organic peroxide in an amount of 0.01 to 20 parts by mass, and
(D) a radically activated hydrosilylation reaction catalyst in an amount of 0.1 to 5,000 ppm in terms of metal atom amount based on a total mass of the component (A) and the component (B).

[2]: The method for producing a thin wafer according to the above [1], wherein the thermosetting silicone resin composition used further comprises, as component (E), a non-functional organopolysiloxane in an amount of 0.1 to 200 parts by mass.
[3]: The method for producing a thin wafer according to the above [2], wherein the non-functional organopolysiloxane as the component (E) is composed of dimethylpolysiloxane, and a 30% by mass toluene solution thereof has a viscosity at 25°C of 100 to 500,000 mPa·s.
[4]: The method for producing a thin wafer according to any of the above [1] to [3], wherein the organic peroxide is at least one selected from the group consisting of a diacyl peroxide, a peroxy ester, a dialkyl peroxide, a percarbonate, a peroxy ketal, a hydroperoxide, and a ketone peroxide.
[5]: The method for producing a thin wafer according to any of the above [1] to [4], wherein the organic peroxide has a 10-hour half-life temperature of 40°C or higher and a 1-minute half-life temperature of 200°C or lower.
[6]: The method for producing a thin wafer according to any of the above [1] to [5], wherein the thermosetting silicone resin composition used further comprises, as component (F), a hydrosilylation reaction control agent in an amount of 0.001 to 10 parts by mass based on a total mass of the components (A) and (B).
[7]: The method for producing a thin wafer according to any of the above [1] to [6], wherein the thermosetting silicone resin composition has a 180° peel strength at 25°C after curing of 2 gf or more and 500 gf or less when a test specimen with a width of 25 mm is peeled from a silicon substrate.
[8]: The method for producing a thin wafer according to any of the above [1] to [7], wherein the thermosetting silicone resin composition has a storage modulus at 25°C after curing of 1,000 Pa or more and 1,000 MPa or less.
[9]: The method for producing a thin wafer according to any of the above [1] to [8], comprising the steps of:

(a) allowing a circuit-forming surface of a wafer having the circuit-forming surface on a front surface and a circuit-free surface on a back surface to peelably adhere to a support using the temporary adhesive for wafer processing to form a wafer laminate;
(b) thermally curing the temporary adhesive;
(c) grinding or polishing the circuit-free surface of the wafer in the wafer laminate;
(d) subjecting the circuit-free surface of the wafer to processing; and
(e) peeling off the wafer subjected to the processing from the support.

[10]: A temporary adhesive for wafer processing applicable to a thin wafer or a wafer laminate, wherein the temporary adhesive for wafer processing is composed of a thermosetting silicone resin composition comprising the following components:

(A) an organopolysiloxane having two or more alkenyl groups in one molecule in an amount of 100 parts by mass,
(B) an organohydrogenpolysiloxane comprising two or more silicon atom-bonded hydrogen atoms (SiH groups) in one molecule in an amount such that a mole ratio of a total of the SiH groups in component (B) to a total of alkenyl groups in component (A) is from 0.3 to 10,
(C) an organic peroxide in an amount of 0.01 to 20 parts by mass, and
(D) a radically activated hydrosilylation reaction catalyst in an amount of 0.1 to 5,000 ppm in terms of metal atom

amount based on a total mass of the component (A) and the component (B).

[11]: The temporary adhesive for wafer processing according to the above [10], wherein the thermosetting silicone resin composition further comprises, as component (E), a non-functional organopolysiloxane in an amount of 0.1 to 200 parts by mass.
[12]: The temporary adhesive for wafer processing according to the above [11], wherein the non-functional organopolysiloxane as the component (E) is composed of dimethylpolysiloxane, and a 30% by mass toluene solution thereof has a viscosity at 25°C of 100 to 500,000 mPa·s.
[13]: The temporary adhesive for wafer processing according to any of the above [10] to [12], wherein the organic peroxide is at least one selected from the group consisting of a diacyl peroxide, a peroxy ester, a dialkyl peroxide, a percarbonate, a peroxy ketal, a hydroperoxide, and a ketone peroxide.
[14]: The temporary adhesive for wafer processing according to any of the above [10] to [13], wherein the organic peroxide has a 10-hour half-life temperature of 40°C or higher and a 1-minute half-life temperature of 200°C or lower.
[15]: The temporary adhesive for wafer processing according to any of the above [10] to [14], wherein the thermosetting silicone resin composition further comprises, as component (F), a hydrosilylation reaction control agent in an amount of 0.001 to 10 parts by mass based on a total mass of the component (A) and the component (B).
[16]: The temporary adhesive for wafer processing according to any of the above [10] to [12], wherein the thermosetting silicone resin composition has a 180° peel strength at 25°C after curing of 2 gf or more and 500 gf or less when a test specimen with a width of 25 mm is peeled from a silicon substrate.
[17]: The temporary adhesive for wafer processing according to any of the above [10] to [16], wherein the thermosetting silicone resin composition has a storage modulus at 25°C after curing of 1,000 Pa or more and 1,000 MPa or less.
[18]: A wafer laminate comprising: a support; a temporary adhesive layer obtained from the temporary adhesive for wafer processing according to any of the above [10] to [17] stacked on the support; and a wafer having a circuit-forming surface on a front surface and a circuit-free surface on a back surface, wherein the temporary adhesive layer is peelably adhered to the front surface of the wafer.

It should be noted that the present invention is not limited to the above-described embodiments. The embodiments are just examples, and any examples that substantially have the same feature and demonstrate the same functions and effects as those in the technical concept disclosed in claims of the present invention are included in the technical scope of the present invention.

## Claims

1. A method for producing a thin wafer using a thermosetting silicone resin composition as a temporary adhesive for wafer processing for allowing a wafer to temporarily adhere to a support,
wherein the thermosetting silicone resin composition can be cured only by heating and comprises the following components:

(A) an organopolysiloxane having two or more alkenyl groups in one molecule in an amount of 100 parts by mass,
(B) an organohydrogenpolysiloxane comprising two or more silicon atom-bonded hydrogen atoms (SiH groups) in one molecule in an amount such that a mole ratio of a total of SiH groups in component (B) to a total of alkenyl groups in component (A) is from 0.3 to 10,
(C) an organic peroxide in an amount of 0.01 to 20 parts by mass, and
(D) a radically activated hydrosilylation reaction catalyst in an amount of 0.1 to 5,000 ppm in terms of metal atom amount based on a total mass of the component (A) and the component (B).

2. The method for producing a thin wafer according to claim 1, wherein the thermosetting silicone resin composition used further comprises, as component (E), a non-functional organopolysiloxane in an amount of 0.1 to 200 parts by mass.

3. The method for producing a thin wafer according to claim 2, wherein the non-functional organopolysiloxane as the component (E) is composed of dimethylpolysiloxane, and a 30% by mass toluene solution thereof has a viscosity at 25°C of 100 to 500,000 mPa·s.

4. The method for producing a thin wafer according to claim 1, wherein the organic peroxide is at least one selected from the group consisting of a diacyl peroxide, a peroxy ester, a dialkyl peroxide, a percarbonate, a peroxy ketal, a hydroperoxide, and a ketone peroxide.

5. The method for producing a thin wafer according to claim 1, wherein the organic peroxide has a 10-hour half-life temperature of 40°C or higher and a 1-minute half-life temperature of 200°C or lower.

6. The method for producing a thin wafer according to claim 1, wherein the thermosetting silicone resin composition used further comprises, as component (F), a hydrosilylation reaction control agent in an amount of 0.001 to 10 parts by mass based on a total mass of the components (A) and (B).

7. The method for producing a thin wafer according to claim 1, wherein the thermosetting silicone resin composition has a 180° peel strength at 25°C after curing of 2 gf or more and 500 gf or less when a test specimen with a width of 25 mm is peeled from a silicon substrate.

8. The method for producing a thin wafer according to claim 1, wherein the thermosetting silicone resin composition has a storage modulus at 25°C after curing of 1,000 Pa or more and 1,000 MPa or less.

9. The method for producing a thin wafer according to any one of claims 1 to 8, comprising the steps of:

(a) allowing a circuit-forming surface of a wafer having the circuit-forming surface on a front surface and a circuit-free surface on a back surface to peelably adhere to a support using the temporary adhesive for wafer processing to form a wafer laminate;
(b) thermally curing the temporary adhesive;
(c) grinding or polishing the circuit-free surface of the wafer in the wafer laminate;
(d) subjecting the circuit-free surface of the wafer to processing; and
(e) peeling off the wafer subjected to the processing from the support.

10. A temporary adhesive for wafer processing applicable to a thin wafer or a wafer laminate, wherein the temporary adhesive for wafer processing is composed of a thermosetting silicone resin composition comprising the following components:

(A) an organopolysiloxane having two or more alkenyl groups in one molecule in an amount of 100 parts by mass,
(B) an organohydrogenpolysiloxane comprising two or more silicon atom-bonded hydrogen atoms (SiH groups) in one molecule in an amount such that a mole ratio of a total of the SiH groups in component (B) to a total of alkenyl groups in component (A) is from 0.3 to 10,
(C) an organic peroxide in an amount of 0.01 to 20 parts by mass, and
(D) a radically activated hydrosilylation reaction catalyst in an amount of 0.1 to 5,000 ppm in terms of metal atom amount based on a total mass of the component (A) and the component (B).

11. The temporary adhesive for wafer processing according to claim 10, wherein the thermosetting silicone resin composition further comprises, as component (E), a non-functional organopolysiloxane in an amount of 0.1 to 200 parts by mass.

12. The temporary adhesive for wafer processing according to claim 11, wherein the non-functional organopolysiloxane as the component (E) is composed of dimethylpolysiloxane, and a 30% by mass toluene solution thereof has a viscosity at 25°C of 100 to 500,000 mPa·s.

13. The temporary adhesive for wafer processing according to claim 10, wherein the organic peroxide is at least one selected from the group consisting of a diacyl peroxide, a peroxy ester, a dialkyl peroxide, a percarbonate, a peroxy ketal, a hydroperoxide, and a ketone peroxide.

14. The temporary adhesive for wafer processing according to claim 10, wherein the organic peroxide has a 10-hour half-life temperature of 40°C or higher and a 1-minute half-life temperature of 200°C or lower.

15. The temporary adhesive for wafer processing according to claim 10, wherein the thermosetting silicone resin composition further comprises, as component (F), a hydrosilylation reaction control agent in an amount of 0.001 to 10 parts by mass based on a total mass of the component (A) and the component (B).

16. The temporary adhesive for wafer processing according to claim 10, wherein the thermosetting silicone resin composition has a 180° peel strength at 25°C after curing of 2 gf or more and 500 gf or less when a test specimen with a width of 25 mm is peeled from a silicon substrate.

**17.** The temporary adhesive for wafer processing according to claim 11, wherein the thermosetting silicone resin composition has a storage modulus at 25°C after curing of 1,000 Pa or more and 1,000 MPa or less.

**18.** A wafer laminate comprising: a support; a temporary adhesive layer obtained from the temporary adhesive for wafer processing according to any one of claims 10 to 17 stacked on the support; and a wafer having a circuit-forming surface on a front surface and a circuit-free surface on a back surface, wherein the temporary adhesive layer is peelably adhered to the front surface of the wafer.

## INTERNATIONAL SEARCH REPORT

International application No.
**PCT/JP2024/009173**

**A. CLASSIFICATION OF SUBJECT MATTER**

***H01L 21/304***(2006.01)i; ***C09J 11/06***(2006.01)i; ***C09J 183/04***(2006.01)i; ***H01L 21/683***(2006.01)i
FI: H01L21/304 622J; H01L21/304 631; H01L21/68 N; C09J183/04; C09J11/06

According to International Patent Classification (IPC) or to both national classification and IPC

**B. FIELDS SEARCHED**

Minimum documentation searched (classification system followed by classification symbols)

H01L21/304; C09J11/06; C09J183/04; H01L21/683

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | WO 2021/112070 A1 (SHIN-ETSU CHEMICAL CO., LTD.) 10 June 2021 (2021-06-10) entire text | 1-18 |
| A | WO 2021/220929 A1 (SHIN-ETSU CHEMICAL CO., LTD.) 04 November 2021 (2021-11-04) entire text, all drawings | 1-18 |
| A | WO 2021/065547 A1 (SHIN-ETSU CHEMICAL CO., LTD.) 08 April 2021 (2021-04-08) entire text, all drawings | 1-18 |

☐ Further documents are listed in the continuation of Box C.  ☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **17 May 2024** | **28 May 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (July 2022)

**INTERNATIONAL SEARCH REPORT**
**Information on patent family members**

International application No.
**PCT/JP2024/009173**

| Patent document cited in search report | Publication date (day/month/year) | Patent family member(s) | Publication date (day/month/year) |
|---|---|---|---|
| WO 2021/112070 A1 | 10 June 2021 | US 2023/0002647 A1<br>entire text<br>EP 4071223 A1<br>KR 10-2022-0108799 A<br>CN 114868232 A<br>TW 202134386 A | |
| WO 2021/220929 A1 | 04 November 2021 | US 2023/0088354 A1<br>entire text, all drawings<br>EP 4144808 A1<br>CN 115485814 A<br>KR 10-2023-0005219 A<br>TW 202204517 A | |
| WO 2021/065547 A1 | 08 April 2021 | US 2022/0352001 A1<br>entire text, all drawings<br>EP 4039765 A1<br>CN 114521211 A<br>KR 10-2022-0075215 A<br>TW 202130776 A | |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2004064040 A
- JP 2006328104 A
- US 7541264 B1